# EUROPÄISCHE PATENTSCHRIFT

(11) **EP 1 875 517 B1**
(45) Veröffentlichungstag und Bekanntmachung des Hinweises auf die Patenterteilung: **21.07.2010**
(21) Anmeldenummer: 06722795.9
(22) Anmeldetag: 11.04.2006
(51) Int. Cl.: H01L 31/075

(54) **HETEROKONTAKTSOLARZELLE MIT INVERTIERTER SCHICHTSTRUKTURGEOMETRIE**
HETEROCONTACT SOLAR CELL WITH INVERTED GEOMETRY OF ITS LAYER STRUCTURE
CELLULE SOLAIRE A HETEROCONTACT PRESENTANT UNE GEOMETRIE INVERSEE DE STRUCTURE DE COUCHES

(30) Priorität: 20.04.2005 DE 102005019225
(43) Veröffentlichungstag der Anmeldung: 09.01.2008
(73) Patentinhaber: Helmholtz-Zentrum Berlin für Materialien und Energie GmbH, 14109 Berlin (DE)
(72) Erfinder: ABDALLAH, Ossamah, 12055 Berlin (DE); CITARELLA, Guiseppe, 90429 Nürnberg (DE); KUNST, Marinus, 10623 Berlin (DE); WUNSCH, Frank, 10787 Berlin (DE)
(74) Vertreter: Rudolph, Margit
(86) Internationale Anmeldenummer: PCT/DE2006/000670
(87) Internationale Veröffentlichungsnummer: WO 2006/111138

(56) Entgegenhaltungen:
- EP-A- 0 500 067
- EP-A- 1 519 422
- US-A- 4 498 092
- US-A- 4 620 058

## Beschreibung

Die Erfindung bezieht sich auf eine Heterokontaktsolarzelle in Schichtstruktur mit einem Absorber aus p- oder n-typ dotiertem kristallinem Halbleitermaterial, einem Emitter aus einem zum Absorber entgegengesetzt dotierten amorphen Halbleitermaterial, einer intrinsischen Zwischenschicht aus amorphem Halbleitermaterial zwischen Absorber und Emitter, einer Deckschicht auf der lichtzugewandten Seite des Absorbers, einer ein Minoritätsladungsträger reflektierendes Oberflächenfeld ausbildenden Schicht sowie mit einer ohmschen Kontaktierungsstruktur mit einer minimierten Beschattungsfläche auf der lichtzugewandten Seite des Absorbers und einer ohmschen Kontaktierungsstruktur auf der lichtabgewandten des Absorbers.

### Stand der Technik

Heterokontaktsolarzellen mit kristallinem und amorphem Silizium gewinnen zunehmend an technischer Bedeutung. Der übliche Aufbau einer Heterokontaktsolarzelle ist beispielsweise aus der **Veröffentlichung I** von K. Brendel et al.: "Interface properties of a-Si:H/c-Si heterostructures" (Annual Report 2003, Hahn-Meitner-Institut, 78/79) bekannt. Auf der lichtzugewandten Seite des zentralen Absorbers aus kristallinem, p-dotierten Silizium (c-Si(p)) und mikrokristallinem Silizium (µc-Si) sind ein Emitter aus amorphem, mit Wasserstoff "legiertem" bzw. angereichertem, n-dotiertem amorphem Silizium (a-Si:H(n+)) und eine transparente leitfähige Oxidschicht (TCO) als Deckschicht unter fingerförmigen Frontkontakten angeordnet. Der Emitter auf der lichtzugewandten Oberseite des Absorbers absorbiert Strahlung, die den Absorber entsprechend nicht mehr erreichen kann. Auf der lichtabgewandten Unterseite befindet sich zwischen dem Absorber und einem ganzflächigen Rückkontakt eine amorphe, mit Wasserstoff angereicherte p-hochdotierte amorphe Siliziumschicht (a-Si:H(p+)) zur Ausbildung eines Minoritätsladungsträger reflektierenden Oberflächenfeld (Back Surface Field BSF). Das Dokument US 4,620 058 beschreibt eine Solarzelle mit Kristallinen und amorphen Schichten.

Wie bei jedem Solarzellentyp leidet auch die Heterokontaktsolarzelle mit bekannter Schichtstrukturgeometrie mit einer Positionierung des Emitters auf der lichtzugewandten Oberseite des Absorbers an Verlusten bei der Umwandlung der in die Solarzelle eindringenden Lichtenergie in elektrische Energie. Grundsätzlich zeigen amorphe Bereiche aufgrund ihrer ungeordneten Struktur schlechtere Transporteigenschaften für Ladungsträger als kristalline Bereiche. Ein Verlustprozess in der Umwandlungskette besteht darin, dass nicht alle Photonen der einfallenden Strahlung in einem "aktiven" Bereich der Solarzelle zu Elektronen-/Loch-Paaren gewandelt werden. Unter "aktivem Bereich" ist dabei diejenige Zone in der Solarzelle zu verstehen, in der die Elektronen und Löcher aufgrund hinreichend großer Lebensdauer gesammelt werden und nachfolgend über die ohmschen Kontaktierungssysteme abfließen können. Notwendige Voraussetzung für eine effizient arbeitende Solarzelle ist, dass ein möglichst großer Strahlungsanteil im aktiven Bereich absorbiert wird. Bei Heterokontaktsolarzellen ist dieser aktive Bereich der Absorber aus kristallinem Silizium, während der hochdotierte Emitter aus amorphem Silizium, durch den das Licht in den Absorber einfällt, dem entgegen als "inaktiver Bereich" zu bezeichnen ist, weil die in dieser Schicht erzeugten Elektronen und Löcher nur eine vergleichsweise geringe Lebensdauer haben und daher kaum eingesammelt werden können. Durch den hohen Absorptionskoeffizienten des amorphen Emittermaterials wird ein erheblicher Anteil des auftreffenden Sonnenlichts im Emitter absorbiert.

Zur Verringerung der genannten Verlustprozesse bei Heterokontaktsolarzellen mit einer konventionellen Schichtstrukturgeometrie mit einem Emitter auf der lichtzugewandten Oberseite des Absorbers ist es aus der EP 1 187 223 A2**,** von der die Erfindung als nächstliegendem Stand der Technik ausgeht, für die so genannte "HIT"-Solarzelle (Heterojunction with Intrinsic Thin-layer) der Firma Sanyo bekannt, entweder die Dicke des Emitters aus hochdotiertem amorphem Silizium zu verringern, wobei eine Mindestschichtdicke von 5 nm zur vollständigen Ausbildung des pn-Heterokontaktes eingehalten werden muss, oder die Lichtabsorption im Emitter durch eine Vergrößerung der Bandlücke zu reduzieren. Dazu wird das amorphe Silizium des Emitters mit Kohlenstoff legiert. Die in der EP 1 187 223 A2 offenbarte gattungsgemäße Heterokontakt-solarzelle weist eine Schichtstruktur mit einem n-typ dotierten kristallinen Siliziumwafer in der Mitte als Absorber auf. Auf beiden Seiten des Absorbers ist ein Heterokontakt zu benachbarten amorphen Siliziumschichten aufgebaut. Auf der lichtzugewandten Seite des Absorbers sind zwei intrinsische Zwischenschichten, der amorphe Emitter und eine transparente leitfähige Elektrode (ITO) als Deckschicht vorgesehen. Auf der lichtabgewandten Seite des Absor-bers sind vor einer sammelnden Rückelektrode zur Ausbildung eines BSF zumindest zwei weitere amorphe Schichten vorgesehen, von denen die eine undotiert und die andere wie der Absorber n-typ, jedoch stark dotiert ist. Auf beiden Seiten weist die Heterokontaktsolarzelle gitterförmige Kontaktierungssysteme auf den Ladungsträger sammelnden ITO-Schichten auf.

Somit weist auch die bekannte HIT-Solarzelle eine transparente Leitschicht (TCO, ITO) auf der lichtzugewandten Oberseite auf, um die im schlechter leitenden, amorphen Emitter gesammelten Ladungen abzuführen. Der **Veröffentlichung II** von A.G. Ulyashin et al.: "The influence of the amorphous silicon deposition temperature on the efficiency of the ITO/a-Si:H/c-Si Heterojunction (HJ) solar cells and properties of interfaces" (Thin Solid Films 403-404 (2002) 259-362) ist zu entnehmen, dass die Abscheidung dieser transparenten Leitschicht auf dem amorphen Emitter im Verdacht steht, die elektronischen Eigenschaften an der Grenzfläche zwischen amorphem und kristallinem Silizium (Emitter/Absorber) zu verschlechtern.

Weiterhin ist aus der DE 100 45 249 A1 eine kristalline Solarzelle bekannt, bei der der kristalline Emitter auf der lichtabgewandten Seite des Absorbers angeordnet ist. Dort ist er streifenförmig unter Anwendung eines Herstellungsprozesses bei hoher Temperatur ausgebildet und wird mit kristallinen Streifen gegensätzlicher Dotierung verschachtelt, die ein BSF ausbilden. Diese reinkristalline, interdigitale Halbleiterstruktur ist nur in einem sehr komplizierten Herstellungsprozess erzeugbar und dient der ausschließlichen Rückseitenkontaktierung, bei der beide ohmschen Kontaktierungsstrukturen auf der lichtabgewandten Unterseite der Solarzelle angeordnet und ebenfalls ineinander verschachtelt sind. Unterhalb der auf der lichtzugewandten Oberseite des Absorbers vorgesehenen Antireflexschicht, die in eine Verkapselung integriert ist, weist die bekannte Solarzelle noch eine zusätzliche Passivierungsschicht auf, die der Verringerung der Rekombination von lichterzeugten Ladungsträgern auf der Vorderseite der Solarzelle dient, jedoch auch zusätzlich Licht absorbiert. Weitere interdigitale Solarzellen sind auch aus der US 4.927.770 mit sehr kleinen Emitterbereichen und aus der US 2004/0200520 A1**,** bei der größere Emitterbereiche in Gräben vorgesehen sind, bekannt. Bei beiden bekannten interdigitalen Solarzellen ist auf der lichtzugewandten Oberseite neben einer Passivierungsschicht und einer Antireflexschicht auch eine dotierte Frontschicht zur Ausbildung eines Minoritätsladungsträger reflektierenden Oberflächenfelds (Front Surface Field FSF) vorgesehen. Insbesondere die das Oberflächenfeld ausbildende Schicht wirkt, wenn es sich um eine stark dotierte Si-Schicht handelt, stark absorbierend und verringert damit den Lichteinfall in den aktiven Bereich der Solarzelle und die Ladungsträgerausbeute. Auf der lichtzugewandten Oberseite ist die Ausbildung eines FSF jedoch von besonderer Bedeutung, da hier durch den starken Lichteinfall eine hohe Ladungsträgererzeugung auftritt, deren Rekombination minimiert werden muss.

Aus der DE 100 42 733 A1 ist eine ebenfalls reinkristalline Dünnschicht-Solarzelle mit einem transparenten Glassuperstrat auf der Lichteinfallsseite bekannt, die einen p-typ dotierten polykristallinen Absorber (p-pc-Si) mit einer Kontaktierungsschicht zwischen dem Absorber und dem Glassuperstrat aus p-hochdotiertem polykristallinen Silizium (p⁺-pc-Si), die gleichzeitig als transparente Elektrode und als Schicht zum Aufbau eines FSF dient, aufweist. Die Erzeugung des FSF und die Stromsammlung durch die transparente Elektrode auf der lichtzugewandten Seite werden jedoch auch hier mit Absorptionsverlusten im Eintrittsfenster erkauft. Eine Antireflexschicht auf der lichtzugewandten Seite ist nicht vorgesehen, deren Funktion muss von dem Glassuperstrat übernommen werden. Auf der lichtabgewandten Seite des Absorbers befindet sich direkt auf dem Absorber der Emitter aus n-hochdotiertem mikrokristallinem Silizium (n⁺-µc-Si) mit einer rauen abgewandten Oberfläche, auf der eine Aluminiumschicht als rückreflektierender Kontaktschicht und Elektrode angeordnet ist.

### Aufgabenstellung

Ausgehend von der gattungsgemäßen Heterokontaktsolarzelle, wie sie im Zusammenhang mit der HIT-Solarzelle oben näher beschrieben ist, besteht die **Aufgabe** für die vorliegende Erfindung darin, eine möglichst einfach herstellbare Schichtstrukturgeometrie für eine Heterokontaktsolarzelle mit geringen optischen Verlusten zu schaffen, die ohne eine transparent leitfähige Elektrode (TCO) auf der lichtzugewandten Seite auskommt und trotzdem eine zu bekannten Heterokontaktsolarzellen mit konventioneller Schichtstrukturgeometrie vergleichbare Umsetzungseffizienz bei der Gewinnung von elektrischem Strom aus Sonnenenergie liefert. Es soll eine möglichst kurze Energierücklaufzeit für die erzeugten Heterokontaktsolarzellen durch einen möglichst geringen Material-, Zeit- und vor allem Energieeinsatz bei einfacher und kostengünstiger Herstellungsweise erreicht werden. Die erfindungsgemäße **Lösung** für diese Aufgabe ist dem Hauptanspruch zu entnehmen. Vorteilhafte Modifikationen der Erfindung werden in den Unteransprüchen aufgezeigt und im Folgenden im Zusammenhang mit der Erfindung näher erläutert.

Die erfindungsgemäße Heterokontaktsolarzelle weist im grundsätzlichen Unterschied zu bekannten Heterokontaktsolarzellen eine invertierte Schichtstrukturgeometrie und damit einen invertierten Heterokontakt auf. Der amorphe Emitter ist auf der lichtabgewandten Unterseite des Absorbers angeordnet. Hinter dem Absorber ist die Intensität des einfallenden Lichts schon so stark verringert, dass in den Emitter kaum noch Strahlung eindringt und dort absorbiert wird, sodass die Absorptionsverluste gering gehalten werden können. Auf der lichtzugewandten Oberseite des Absorbers ist bei der erfindungsgemäßen Heterokontaktsolarzelle lediglich eine einzelne transparente Antireflexschicht mit verbesserten Antireflexeigenschaften als Deckschicht angeordnet, die aufgrund der Materialwahl gleichzeitig als elektrisch wirkende Passivierungsschicht eine Ladungsträgerrekombination durch Ausbildung eines Minoritätsladungsträger rückstreuenden Oberflächenfeldes (FSF) verhindert. Die Antireflexeigenschaften der Antireflex-schicht werden durch die Wahl ihres Materials bedingt, das einen Brechungsindex (n_{ARS}) aufweisen muss, der größer als der Brechungsindex von Luft(n_{L}), aber kleiner als der Brechungsindex des kristallinen Halbleitermaterials des Absorbers (n_{AB}) ist (n_{L}<n_{ARS}<n_{AB}). Durch die doppelte Funktion der Deckschicht als transparente Antireflexschicht und als Passivierungsschicht entfällt insbesondere eine transparent leitfähige Elektrode (TCO) auf der lichtzugewandten Seite, da deren Funktion der Stromableitung durc ein feines Kontaktgitter als oberes Konatkierungssystem übernommen werden kann. Außerdem entfallen weitere Schichten, insbesondere hochdotierte Si-FSF-Schichten und damit stark absorbierende Passivierungsschichten, und deren Präparation auf der Solarzellenoberseite. Durch den Wegfall zusätzlicher Deckschichten wird der Herstellungsaufwand bezüglich Material-, Zeit- und Energieeinsatz bei der Heterokontaktsolarzelle nach der Erfindung bedeutsam reduziert und vereinfacht.

Im Unterschied zu den bekannten interdigitalen kristallinen Solarzellen, die einen kristallinen, streifenförmigen Emitter auch auf der lichtabgewandten Absorberseite aufweisen, ist der amorphe Emitter der erfindungsgemäßen Heterokontaktsolarzelle als durchgängige Schicht ausgebildet, sodass er einfacher herstellbar ist, effizient arbeitet und einfach kontaktiert werden kann. Darüber hinaus wird der Emitter bei der Heterokontaktsolarzelle nicht durch Eindiffusion der entsprechenden Dotierspezies bei Temperaturen über 900ºC gebildet, sondern beispielsweise durch plasmagestütztes Abscheiden aus der Gasphase (PECVD) bei Substrattemperaturen von unter 250ºC erzeugt.

Weiterhin können bei der erfindungsgemäßen Heterokontaktsolarzelle durch die Separation von transparenter Antireflexschicht und Emitter deren Schichtdicken unabhängig voneinander optimiert werden. So kann der Emitter auf der lichtabgewandten Unterseite des Absorbers in größerer Schichtdicke ausgeführt werden als auf dessen lichtzugewandter Oberseite, wodurch eine gute, stabile Raumladungszone erzeugt wird. Die elektronischen Eigenschaften der aktiven Grenzfläche zwischen Emitter und Absorber werden dadurch verbessert. Bei der Erzeugung der transparenten Antireflexschicht wiederum muss keine Rücksicht mehr auf darunter liegende Schichten und einen Einfluss auf deren elektronische Eigenschaften genommen werden.

Die im Absorber generierten Ladungsträger werden am Heterokontakt zwischen kristallinem Absorber und amorphen Emitter in der Raumladungszone getrennt und über die ohmschen Kontaktierungsstrukturen abgeführt. Dabei durchdringt die-eine ohmsche Kontaktierungsstruktur auf der lichtzugewandten Oberseite des Absorbers, die mit einer minimierten Beschattungsfläche ausgebildet ist, die transparente Antireflexschicht. Die andere ohmsche Kontaktierungsstruktur ist großflächig auf dem Emitter auf der lichtabgewandten Unterseite des Absorbers ausgebildet. Vorteilhaft können auch unterhalb der die transparente Antireflexschicht durchdringenden Kontaktierungsstruktur im Absorber Ladungsträger reflektierende Zonen ausgebildet sein, sodass zusammen mit dem von der transparenten Antireflexschicht bewirkten Ladungsträger rückstreuenden Oberflächenfeld (FSF) auf der gesamten Oberfläche des Absorbers ein geschlossenes Oberflächenfeld erzeugt wird. Es wird zur Kontaktierung des Emitters keine transparent leitfähige Oxidschicht (TCO : z.B. ITO) als Elektrode mehr benötigt, deren Abscheidung auf dem amorphen Emitter in Verdacht steht, die elektronischen Eigenschaften am Heteroübergang zu verschlechtern (s.o.). Diese technologische Schwierigkeit wird bei der Erfindung durch eine sanfte Metallisierung des amorphen Emitters, der eine gute großflächige Kontaktierung erlaubt, zur Erzeugung der großflächigen Kontaktierungsstruktur über beispielsweise thermische Verdampfung vermieden. Dabei kann die großflächige Kontaktierungsstruktur die gesamte Unterseite des Emitters überdecken oder durch Anwendung einer Maskentechnik größere Flächenbereiche davon.

Besonders günstig wirken sich die zuvor aufgeführten Vorteile auf die Heterokontaktsolarzelle nach der Erfindung mit invertiertem Heteroübergang aus, wenn der Absorber aus n-typ dotiertem kristallinem Silizium und der Emitter aus p-typ dotiertem amorphem Silizium mit einer intrinsischen, d.h. undotierten, amorphen Zwischenschicht bestehen. Bei einer derartigen Materialwahl kann ein technisch gut beherrschbarer, n-leitender Absorber aus Silizium mit sehr guten Transporteigenschaften und einer hohen Ladungsträgerlebensdauer, das mono-, multi- oder auch mikro-kristallin ausgebildet sein kann. Bei der Wahl eines solchen Materialsystems ist es möglich, die FSF-bildende Passivierungsschicht nicht - wie aus dem Stand der Technik bekannt - aus Siliziumoxid, sondern aus Siliziumnitrit zu erzeugen. Dessen optischer Brechungsindex liegt zwischen dem von Luft und Silizium, sodass die Passivierungsschicht gleichzeitig als gute transparente Antireflexschicht wirksam ist. Eine entsprechend doppeltfunktionelle transparente Antireflexschicht ist auch möglich, wenn der Absorber p-leitend dotiert ist. Der Brechungsindex des gewählten Materials muss wieder zwischen dem von Luft und Absorber liegen und das Material muss passivierend auf den Absorber einwirken. Weiterhin kann der Silizium-Absorber auf seiner lichtabgewandten Unterseite in einfacher Weise in einem Niedertemperaturprozess durch den Emitter aus amorphem Silizium passiviert werden, wodurch eine sehr geringe Grenzflächenrekombination bedingt wird, da offene Bindungen, so genannte "dangling bonds" sehr effizient chemisch abgesättigt werden. Die Absättigung mit amorphem Silizium, dessen Bandlücke weit oberhalb der des kristallinen Siliziums liegt, ergibt einen sehr guten pn-Heterokontaktübergang. Das amorphe Silizium des Emitters hingegen zeigt starkes Absorptions- und Rekombinationsverhalten. Die Anordnung eines dünnen Emitters hinter dem aktiven Bereich ist somit optimal.

Weiterhin kann die eine ohmsche Kontaktierungsstruktur auf der lichtzugewandten Oberseite des Absorbers als Kontaktfinger oder -gitter aus Silber oder Aluminium und die andere ohmsche Kontaktierungsstruktur auf dem Emitter als dünne, flächige Metallschicht aus Gold oder einem anderen geeigneten Material ausgebildet sein. Beide Edelmetalle sind zwar relativ teuer, werden aber in so geringen Mengen verwendet, dass ihren sehr guten Leit- und Verarbeitungseigenschaften der Vorzug zu geben ist. Zudem ist bei großflächigen Strukturen eine Verdickung der Kontakte mit kostengünstigeren Metallen denkbar. Außerdem kann der Absorber als selbsttragender Wafer, insbesondere Siliziumwafer, in relativ großer Schichtdicke ausgeführt sein. Die Solarzelle nach der Erfindung kann aber auch in Dünnschichttechnik, d.h. mit einzelnen Schichten von Schichtdicken im nm- bis µm-Bereich, ausgeführt sein und durch ein Glassubstrat auf der lichtabgewandten Unterseite des Absorbers die erforderliche Stabilität erhalten. Weitere Anordnungen, Materialsysteme und Herstellungsprozesse können dem nachfolgenden speziellen Beschreibungsteil entnommen werden.

### Ausführungsbeispiele

Ausbildungsformen der Heterokontaktsolarzelle mit invertierter Schichtstrukturgeometrie nach der Erfindung werden nachfolgend anhand der schematischen Figuren näher erläutert. Dabei zeigt :
- **Figur 1**: einen Schichtstrukturquerschnitt durch die Heterokontaktsolarzelle,
- **Figur 2**: ein Diagramm mit einer Dunkel- und Hellkennlinie einer hergestellten Heterokontaktsolarzelle und
- **Figur 3**: ein Diagramm zur spektralen Quantenausbeute der Heterokontaktsolarzelle gemäß Figur 2.

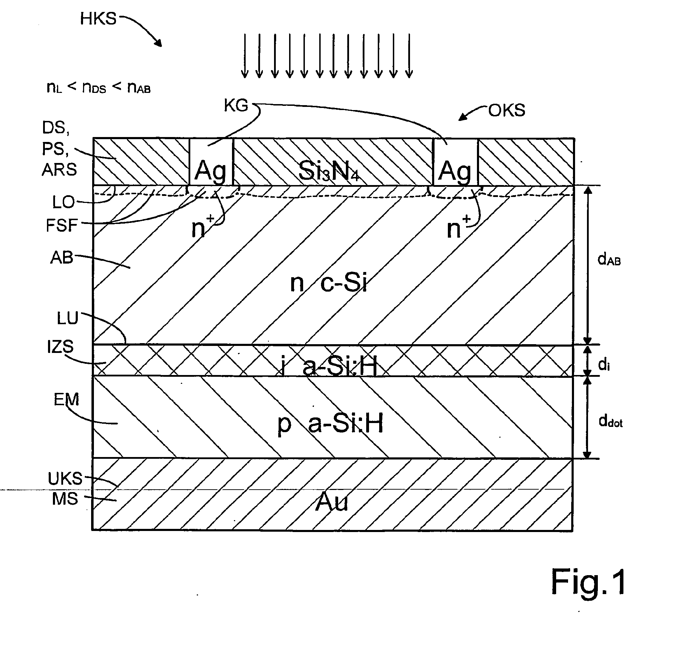

Die **Figur 1** zeigt eine Heterokontaktsolarzelle **HKS** mit einem Absorber **AB,** in dessen lichtzugewandter Oberseite **LO** Lichtstrahlung (natürlich oder künstlich, sichtbar und/oder unsichtbar) einfällt (Pfeile). Der Absorber **AB** besteht aus einem selbsttragenden Wafer der Schichtdicke **d_{AB}** aus n-typ dotiertem kristallinem Silizium n **c-Si.** Dabei kann das verwendete Silizium mono-, poly-, multi- oder mikrokristallin ausgebildet und entsprechend hergestellt sein.

Auf der lichtzugewandten Oberseite **LO** des Absorbers **AB** ist als Deckschicht **DS** eine transparente Antireflexschicht **ARS** aus Siliziumnitrit Si₃N₄ angeordnet, die gleichzeitig als Passivierungsschicht **PS** auf dem Absorber **AB** wirkt und ein Ladungsträger rückstreuendes Oberflächenfeld **FSF** (in **Figur 1** gestrichelt dargestellt) ausbildet zur Vermeidung von Ladungsträgerrekombination auf der Lichteinfallsseit. Die Doppelfunktion der Deckschicht DS ergibt sich durch deren Materialwahl in Abhängigkeit vom Absorbermaterial. Die Antireflexeigenschaften der transparente Antireflexschicht werden durch die Wahl ihres optischen Brechungsindex **n_{ARS}** zwischen dem Brechungsindex **n_{L}** von Luft und dem Brechungsindex **n_{AB}** des Absorbermaterials bedingt **(n_{L}<n_{ARS}<n_{AB}).** Die Passivierungseigenschaften hängen von der elektrischen Wirkung des gewählten Materials auf die Absorberoberfläche ab. Durch die einzige Deckschicht **DS** auf dem Absorber **AB** werden die Photonenverluste durch Absorption gegenüber einem konventionellen Heterokontaktsolarzellenaufbau mit einer Anordnung des Emitters **EM** auf der lichtzugewandten Oberseite **LO** des Absorbers **AB** erheblich reduziert. Außerdem besteht beim Aufbau der transparenten Antireflexschicht **ARS** keine Gefahr, die darunter liegende Schichten und deren elektronische Eigenschaften zu stören.

Bei der Heterokontaktsolarzelle **HKS** mit invertierter Schichtstrukturgeometrie ist der Emitter **EM** auf der lichtabgewandten Unterseite **LU** des Absorbers **AB** angeordnet. Im gewählten Ausführungsbeispiel besteht der Emitter **EM** aus mit Wasserstoff **H** angereichertem amorphem Silizium mit einer p-typ Dotierung **p a-Si:H.** Aufgrund seiner invertierten Positionierung hinter dem Absorber **AB** kann der Emitter **EM** kein Licht absorbieren und somit in seiner Schichtdicke **d_{dot}** individuell, insbesondere auch ausreichend dick, bemessen werden. Da die Beweglichkeit der Ladungsträger in amorphem Silizium sehr viel geringer ist als in kristallinen Silizium, darf **d_{dot}** aber auch nicht zu dick sein. Somit kann **d_{dot}** im Hinblick auf einen geringen Serienwiderstand der Heterokontakt-solarzelle **HKS** optimiert werden. Eine sehr dünne intrinsische (nicht dotierte) Zwischenschicht **IZS** mit der Schichtstärke **dᵢ** zwischen Absorber **AB** und Emitter **EM** ist im gewählten Ausführungsbeispiel aus amorphem Silizium **i a-Si:H** ausgebildet.

Die Heterokontaktsolarzelle **HKS** mit invertierter Schichtstrukturgeometrie weist auf ihrer lichtzugewandten Oberseite eine obere Kontaktierungsstruktur **OKS** auf, die so ausgelegt ist, dass sie den Absorber **AB** mit nur einer minimalen Fläche abschattet, sodass ein maximaler Lichteinfall möglich ist. Dazu kann die Kontaktierungsstruktur **OKS** finger- oder gitterförmig ausgebildet sein. Im gewählten Ausführungsbeispiel wird die obere Kontaktierungsstruktur **OKS** von einem Kontaktgitter **KG** aus Silber **Ag** gebildet. Im Bereich des Kontaktgitters **KG** wird die transparente Antireflexschicht **AR** durchdrungen, sodass direkt unter den Kontaktfingern zunächst kein Minoritätsladungsträger reflektierendes Oberflächenfeld **FSF** ausgebildet ist. Bei der Erzeugung des Kontaktgitters **KG** können aber Maßnahmen (s.u.) ergriffen werden, die zu einer im gewählten Ausführungsbeispiel hoch n-dotierten **n⁺** Einlagerung unterhalb des Kontaktgitters **KG** im Absorber **AB** führen, sodass auch hier ein Minoritätsladungsträger reflektierendes Oberflächenfeld **FSF** (in **Figur 1** strichpunktiert dargestellt) ausgebildet wird. Somit kann die gesamte Oberfläche des Absorbers **AB** passiviert werden.

Auf der Unterseite des Emitters **EM** befindet sich eine untere Kontaktierungsstruktur **UKS,** welche nicht dem Lichteinfall ausgesetzt ist. Folglich muss sie in ihrer Beschattungsfläche auch nicht minimiert sein, sondern kann den schlecht leitenden amorphen Emitter **EM** möglichst großflächig zur Sammlung der getrennten Ladungsträger kontaktieren. Im gewählten Ausführungsbeispiel ist die untere Kontaktierungsstruktur **UKS** als dünne flächige Metallschicht **MS** aus Gold **Au** ausgebildet.

Die in der **Figur 1** dargestellte Heterokontaktsolarzelle **HKS** mit invertierter Schichtstrukturgeometrie kann beispielsweise nach folgendem Ablauf hergestellt werden. Andere Herstellungsverfahren sind jedoch ebenfalls anwendbar.

Auf einen absorbergroßen Abschnitt eines 0,7 bis 1,5 Ωcm n-dotierten Silizium-Wafers zur Bildung des Absorbers **AB** der Schichtdicke **d_{AB}** werden nach bekannter Standardrezeptur Wasserstoff (**H**)-terminierte Oberflächen nasschemisch präpariert. Auf die präparierte Oberfläche wird anschließend bei 325°C bis 345°C mittels Plasma-CVD eine etwa 70 nm dicke Schicht Siliziumnitrit **Si₃N₄** als transparente Antireflexschicht **ARS** abgeschieden. Diese kann anschließend von dem durch Siebdruck einer kommerziell erhältlichen Silberleitpaste mit Phosphorquelle aufgebrachte Kontaktgitter **KG** bei 600°C bis 800°C durchdrungen (Durchfeuern der Kontakte durch die transparente Antireflexschicht **ARS**) werden. Dabei entstehen unterhalb des Kontaktgitters **KG** durch das lokale Eindiffundieren des Phosphors stark n-dotierte Bereiche **n⁺,** die als Minoritätsladungsträger reflektierendes Oberflächenfeld **FSF** die Rekombination der lichtgenerierten Ladungsträger reduzieren und das Minoritätsladungsträger reflektierendes Oberflächenfeld **FSF** von der transparenten Antireflexschicht **ARS** im Bereich des Kontaktgitters **KG** schließen. Alternativ kann die transparente Antireflexschicht **ARS** beispielsweise mit photolithographischen Schritten partiell geöffnet werden, um das Silizium des Absorbers **AB** auf der lichtzugewandten Oberseite **LO** mit aufgedampftem Aluminium als Kontaktgitter **KG** ohmsch zu kontaktieren.

Auf der lichtabgewandten Unterseite **LU** des Absorbers **AB** wird dann nach einem Ätzreinigungsschritt dieser Oberfläche in verdünnter Flusssäure ebenso mit Plasmadeposition amorphes Silizium als Emitter **EM** der Solarzelle **SZ** abgeschieden. Dies erfolgt in zwei Etappen : Zunächst wird eine wenige nm dünne intrinsische Zwischenschicht **IS** der Schichtdicke **dᵢ** undotiertes Silizium (**i a-Si:H**) aufgewachsen und anschließend eine mit etwa 10000 ppm Bor dotierte 20 nm - 40 nm dicke (Schichtdicke **d_{dot}**) Emitterschicht (**p a-Si:H**) aufgebracht.

Der Emitter **EM** wird auf der lichtabgewandten Unterseite **LU** im nächsten Schritt durch Aufdampfen einer etwa 150 nm dicken Metallschicht **MS** aus Gold **Au** metallisiert und auf diese Weise die untere Kontaktierungsstruktur **UKS** gebildet, wobei deren laterale Ausdehnung durch Verwendung verschieden großer Masken festgelegt werden kann.

Alternativ hierzu kann bei Raumtemperatur eine manuelle Präparation der oberen Kontaktierungsstruktur **OKS** auf der transparenten Antireflexschicht **ARS** durch partielles Fortätzen der transparenten Antireflexschicht **ARS** aus Si₃N₄, durch die Benetzung dieser freigelegten Stellen mit Galliumindium-Eutektikum Galn und deren anschließendes Verkapsein mit silberhaltigen Leitklebern erfolgen.

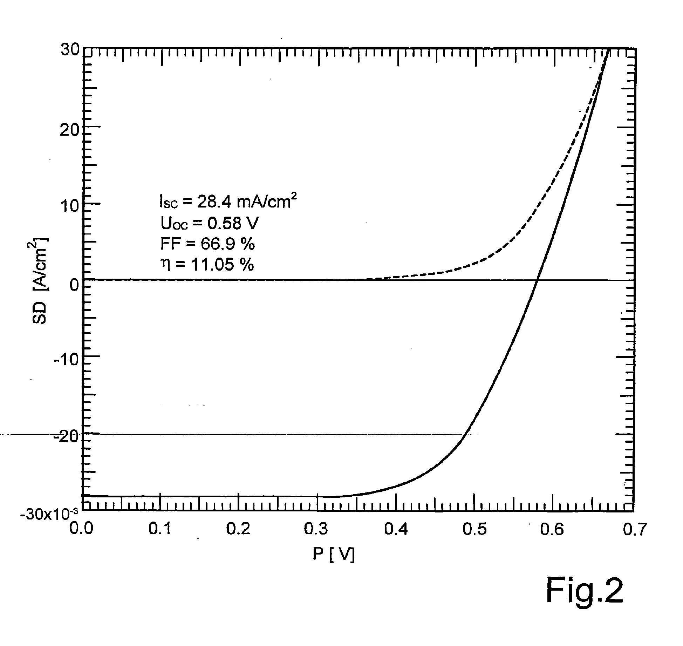

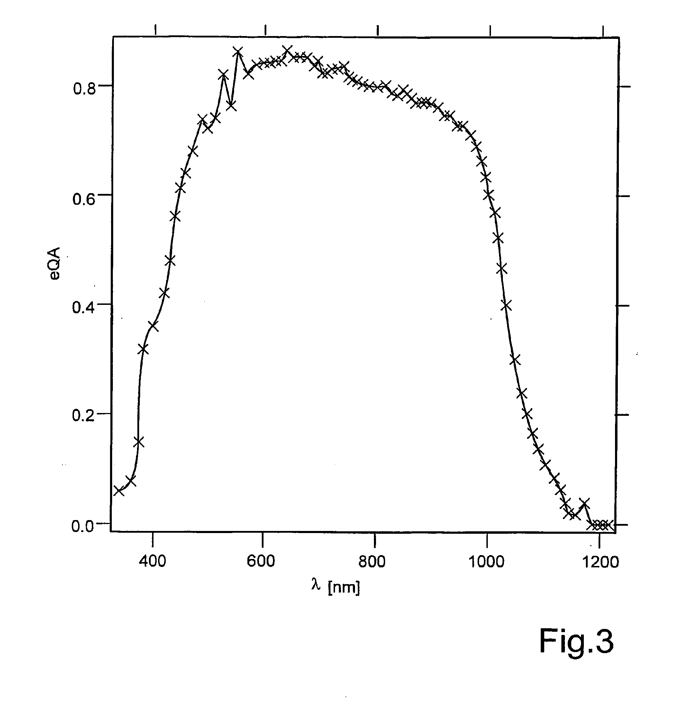

Erste nach dem vorbeschrieben Verfahren hergestellte Heterokontaktsolarzellen **HKS** mit invertierter Schichtstrukturgeometrie gemäß **Figur 1** zeigen einen Wirkungsgrad von über 11,05 % auf (**Figur 2****,** Diagramm mit einer Dunkel- und Hellkennlinie, Stromdichte **SD** in A/cm² über dem Potenzial **P** in V) bei einer für kristallines Silizium typischen externen spektralen Quantenausbeute (**Figur 3**, Diagramm spektrale Quantenausbeute für die Solarzelle gemäß **Figur 2****,** externe Quantenausbeute **eQA** über der Wellenlänge λ in nm). Der durch den relativ hohen Serienwiderstand begrenzte Wirkungsgrad ist durch eine Optimierung der oberen Kontaktierungsstruktur **OKS** noch deutlich steigerbar.

### Bezugszeichenliste

- **AB**: Absorber
- **ARS**: transparente Antireflexschicht
- **d_{AB}**: Schichtdicke Absorber
- **d_{dot}**: Schichtdicke dotierter Emitter
- **dᵢ**: Schichtstärke intrinsische Zwischenschicht
- **DS**: Deckschicht
- **EM**: Emitter
- **FSF**: Minoritätsladungsträger reflektierendes Oberflächenfeld
- **HKS**: heterogene Heterokontaktsolarzelle
- **IZS**: intrinsische Zwischenschicht
- **i a-Si:H**: intrinsisches amorphes Silizium
- **KG**: Kontaktgitter
- **LO**: lichtzugewandte Oberseite
- **LU**: lichtabgewandte Unterseite
- **MS**: Metallschicht
- **n_{AB}**: optischer Brechungsindex Absorber
- **n_{ARS}**: optischer Brechungsindex Antireflexschicht
- **n c-Si**: n-typ dotiertes kristallines Silizium.
- **n_{L}**: optischer Brechungsindex Luft
- **OKS**: obere Kontaktierungsstruktur
- **p a-Si:H**: p-typ dotiertes amorphes Silizium
- **P**: Potenzial
- **PS**: Passivierungsschicht
- **eQA**: externe Quantenausbeute
- **SD**: Stromdichte
- **UKS**: untere Kontaktierungsstruktur

## Patentansprüche

1. Heterokontaktsolarzelle in Schichtstruktur mit einem Absorber aus p- oder n-typ dotiertem kristallinem Halbleitermaterial, einem Emitter aus einem zum Absorber entgegengesetzt dotierten amorphen Halbleitermaterial, einer intrinsischen Zwischenschicht aus amorphem Halbleitermaterial zwischen Absorber und Emitter, einer Deckschicht auf der lichtzugewandten Seite des Absorbers, einer ein Minoritätsladungsträger reflektierendes Oberflächenfeld ausbildenden Schicht sowie mit einer ohmschen Kontaktierungsstruktur mit einer minimierten Beschattungsfläche auf der lichtzugewandten Seite des Absorbers und einer ohmschen Kontaktierungsstruktur auf der lichtabgewandten des Absorbers, **gekennzeichnet durch**
• eine Ausbildung der intrinsischen Zwischenschicht (IZS) mit einer wenige nm betragenden Schichtdicke dᵢ,
• eine Ausbildung des Emitters (EM) mit einer Schichtdicke d_{dot} in einem Bereich zwischen 20 nm und 40 nm,
• eine Ausbildung des Absorbers (AB) als aktivem Bereich mit einer Schichtdicke d_{AB}, in nm bis µm Bereich
• eine Ausbildung der Deckschicht (DS) aus Siliziumnitrid mit einer Schichtstärke d_{DS} in einem Bereich von 70 nm, wobei die Deckschicht (DS) sowohl als transparente Antireflexschicht (ARS) als auch als eine ein Minoritätsladungsträger reflektierendes Oberflächenfeld (FSF) ausbildende Passivierungsschicht (PS) ausgebildet ist,
• eine Anordnung des Emitters (EM) in einer invertierten Schichtstrukturgeometrie auf der lichtabgewandten Unterseite (LU) des Absorbers (AB),
• eine Durchdringung der Deckschicht (DS) von der ohmschen Kontaktierungsstruktur (OKS) auf der lichtzugewandten Oberseite (LO) des Absorbers (AB) und
• eine großflächige Ausbildung der anderen ohmschen Kontaktierungsstruktur (UKS) auf dem Emitter (EM) auf der lichtabgewandten Unterseite (LU) des Absorbers (AB).

2. Solarzelle nach Anspruch 1,
**dadurch gekennzeichnet, dass**
unterhalb der die transparente Deckschicht (DS) durchdringenden Kontaktierungsstruktur (OKS) im Absorber (AB) Ladungsträger reflektierende Bereiche (n⁺) ausgebildet sind.

3. Solarzelle nach Anspruch 1 oder 2,
**dadurch gekennzeichnet, dass**
der Absorber (AB) aus n-typ dotiertem kristallinem Silizium (n c-Si), der Emitter (EM) aus p-typ dotiertem amorphem Silizium (p a-Si:H) und die intrinsische Zwischenschicht (IZS) aus undotiertem amorphem Silizium (i a-Si:H) bestehen.

4. Solarzelle nach einem der Ansprüche 1 bis 3,
**dadurch gekennzeichnet, dass**
die eine ohmsche Kontaktierungsstruktur (OKS) auf der lichtzugewandten Oberseite (LO) des Absorbers (AB) als Kontaktfinger oder -gitter (KG) aus Silber (Ag) und die andere ohmsche Kontaktierungsstruktur (UKS) als dünne flächige Metallschicht (MS) aus Gold (Au) ausgebildet ist.

5. Solarzelle nach einem der Ansprüche 1 bis 4,
**dadurch gekennzeichnet, dass**
der Absorber (AB) aus einem selbsttragenden Wafer besteht.

6. Solarzelle nach einem der Ansprüche 1 bis 5,
**dadurch gekennzeichnet, dass**
ein Dünnschichtaufbau für die Schichten der Solarzelle (SZ) und ein tragendes Glassubstrat auf der lichtabgewandten Unterseite (LU) des Absorbers (AB) vorgesehen sind.

## Claims

1. A heterocontact solar cell in layer structure with an absorber made from p- or n-type doped crystalline semiconductor material, an emitter made from an amorphous semiconductor material doped in the opposite manner to the absorber, an intrinsic intermediate layer made from amorphous semiconductor material between the absorber and the emitter, a cover layer on the side of the absorber facing the light, a layer which forms a surface field which reflects minority charge carriers and also with an ohmic contacting structure with a minimised shadowing area on the side of the absorber facing the light and an ohmic contacting structure on the side of the absorber facing away from the light,
**characterised by**
• a construction of the intrinsic intermediate layer (IZS) with a layer thickness d_{I} comprising a few nm,
• a construction of the emitter (EM) with a layer thickness d_{dot} in a range between 20 nm and 40 nm,
• a construction of the absorber (AB) as an active region with a layer thickness d_{AB}, in the nm to µm range,
• a construction of the cover layer (DS) made from silicon nitride with a layer thickness d_{DS} in a range from 70 nm, wherein the cover layer (DS) is constructed both as a transparent antireflection layer (ARS) and as a passivation layer (PS) which forms a surface field (FSF) which reflects minority charge carriers,
• an arrangement of the emitter (EM) in an inverted layer structure geometry on the absorber's (AB) underside (LU) which faces away from the light,
• a penetration of the cover layer (DS) by the ohmic contacting structure (OKS) on the absorber's (AB) upper side (LO) which faces the light and
• a large-area construction of the other ohmic contacting structure (UKS) on the emitter (EM) on the absorber's (AB) underside (LU) which faces away from the light.

2. The solar cell according to Claim 1,
**characterised in that**
charge carrier reflecting regions (n⁺) are constructed beneath the contacting structure (OKS) which penetrates the transparent cover layer (DS) in the absorber (AB).

3. The solar cell according to Claim 1 or 2, **characterised in that**
the absorber (AB) consists of n-type doped crystalline silicon (n c-Si), the emitter (EM) consists of p-type doped amorphous silicon (p a-Si:H) and the intrinsic intermediate layer (IZS) consists of undoped amorphous silicon (i a-Si:H).

4. The solar cell according to any one of Claims 1 to 3,
**characterised in that**
the one ohmic contacting structure (OKS) on the absorber's (AB) upper side (LO) which faces the light is constructed as a contact finger or grid (KG) made from silver (Ag) and the other ohmic contacting structure (UKS) is constructed as a thin flat metal layer (MS) made from gold (Au).

5. The solar cell according to any one of Claims 1 to 4,
**characterised in that**
the absorber (AB) consists of a self-supporting wafer.

6. The solar cell according to any one of Claims 1 to 5,
**characterised in that**
a thin layer layer structure for the layers of the solar cell (SZ) and a supporting glass substrate on the absorber's (AB) underside (LU) which faces away from the light are provided.

## Revendications

1. Cellule solaire à hétérocontact en structure de couche comprenant un absorbeur à base de matériau semi-conducteur cristallin dopé de type p ou n, un émetteur à base d'un matériau semi-conducteur amorphe, dopé dans le sens opposé à l'absorbeur, une couche intermédiaire intrinsèque à base de matériau semi-conducteur amorphe entre l'absorbeur et l'émetteur, une couche de recouvrement sur le côté tourné vers la lumière de l'absorbeur, une couche formant une zone de surface réfléchissant des porteurs minoritaires et une structure de mise en contact ohmique avec une surface d'ombrage minimisée sur le côté, tourné vers la lumière, de l'absorbeur et une structure de mise en contact ohmique sur le côté, opposé à la lumière, de l'absorbeur,
**caractérisée par**
• une formation de la couche intermédiaire (IZS) intrinsèque avec une épaisseur de couche d₁ de quelques nm,
• une formation de l'émetteur (EM) avec une épaisseur de couche d_{dot} dans une plage comprise entre 20 nm et 40 nm,
• une formation de l'absorbeur (AB) comme zone active avec une épaisseur de couche d_{AB}, dans une plage allant du nm jusqu'au µm,
• une formation de la couche de recouvrement (DS) à base de nitrure de silicium avec une épaisseur de couche d_{DS} dans une plage de 70 nm, la couche de recouvrement (DS) étant conçue aussi bien sous forme de couche antireflet (ARS) transparente que sous forme d'une couche de passivation (PS) formant une zone de surface (FSF) réfléchissant des porteurs minoritaires,
• un agencement de l'émetteur (EM) dans une géométrie de structure de couche inversée sur le côté inférieur (LU) opposé à la lumière, de l'absorbeur (AB),
• une pénétration de la couche de recouvrement (DS) par la structure de mise en contact (OKS) ohmique sur le côté supérieur (LO), tourné vers la lumière, de l'absorbeur (AB), et
• une formation sur une grande surface de l'autre structure de mise en contact ohmique (UKS) sur l'émetteur (EM) sur le côté inférieur (LU) opposé à la lumière de l'absorbeur (AB).

2. Cellule solaire selon la revendication 1,
**caractérisée en ce que**
des zones (n⁺) réfléchissant des porteurs de charge sont conçues au-dessous de la structure de mise en contact (OKS) pénétrant la couche de recouvrement (DS) transparente dans l'absorbeur (AB).

3. Cellule solaire selon la revendication 1 ou 2,
**caractérisée en ce que**
l'absorbeur (AB) est à base de silicium (n c-SI) cristallin dopé de type n, l'émetteur (EM) à base de silicium amorphe (p a-Si:H) dopé de type p et la couche intermédiaire (IZS) intrinsèque à base de silicium (i a-Si:H) amorphe non dopé.

4. Cellule solaire selon l'une quelconque des revendications 1 à 3,
**caractérisée en ce que**
l'une des structures de mise en contact (OKS) ohmiques est conçue sur le côté supérieur (LO), tourné vers la lumière, de l'absorbeur (AB) sous forme de doigt ou de grille de contact (KG) à base d'argent (Ag) et l'autre structure de mise en contact (UKS) ohmique sous forme de couche métallique (MS) plane mince à base d'or (Au).

5. Cellule solaire selon l'une quelconque des revendications 1 à 4,
**caractérisée en ce que**
l'absorbeur (AB) est à base d'une tranche de silicium autoportante.

6. Cellule solaire selon l'une quelconque des revendications 1 à 5,
**caractérisée en ce que**
une structure de couche mince est prévue pour les couches de la cellule solaire (SZ) et un substrat de verre portant est prévu sur le côté inférieur (LU), opposé à la lumière, de l'absorbeur (AB).
